# EUROPEAN PATENT APPLICATION

(11) **EP 4 687 060 A1**
(43) Date of publication of application: **04.02.2026**
(21) Application number: 24192660.9
(22) Date of filing: 02.08.2024
(51) Int. Cl.: G06F 30/15, F02C 7/00, F02C 9/00, G06F 30/20

(54) **METHOD FOR PRODUCING A TECHNICAL SYSTEM WITH AT LEAST TWO ENERGY CONVERSION DEVICES, TECHNICAL SYSTEM**

(71) Applicant: Rolls-Royce Deutschland Ltd & Co KG, 15827 Blankenfelde-Mahlow (DE)
(72) Inventor: Leymann, Tobias, 15827 Blankenfelde-Mahlow (DE); Katsaounis, Michael, 15827 Blankenfelde-Mahlow (DE); Schrüfer, Lukas, 15827 Blankenfelde-Mahlow (DE)

(57) **Abstract**

A method for producing a technical system (1000) comprising at least two pairable energy conversion devices (100), the method comprising: S10: defining a threshold value (VT) for a performance parameter (PE); S20: defining a plurality of pairs (200) of energy conversion devices (100) from an available set (K) of energy conversion devices (100); S30: generating a combined performance parameter (PEC) for each pair (200) of the plurality of pairs (200) of energy conversion devices (100); S40: determining a difference (D) between the combined performance parameter (PEC) and the threshold value (VT) for each pair of the plurality of pairs (200) of energy conversion devices (100); and S50: determining a selected pair (200S) by selecting the pair (200) of energy conversion devices (100) having the smallest difference (D) to the threshold value.

## Description

### TECHNOLOGICAL FIELD

The present disclosure relates to energy conversion device sets and technical systems such as aircrafts or ships in general, and, more specifically, to the process of equipping such technical systems with energy conversion devices.

### BACKGROUND

Energy conversion devices, such as e. g. engines, electrical machines, propulsion devices, motors, generators or stationary power systems, are complex systems, comprising a plurality of interrelated subsystems on many different levels. Energy conversion devices are configured to convert energy from one form to another, such as potential energy, e. g. in chemical or electrical form, into kinetic, e. g. mechanical, energy, or vice versa. Also, other forms of conversion, such as one form of potential energy into another form of potential energy, are conceivable in the scope of this disclosure. The design and production of such energy conversion devices requires thorough planning as well as careful manufacture. Despite such measures, and among other influences due to the above-mentioned complexity, performance parameters related to the performance of an energy conversion device and/or technical system, such as fuel consumption or combustion related parameters, may not come out exactly identically for different energy conversion devices of the same type. Due to the complexity of such technical systems, performance parameters of the included energy conversion devices may not be completely predictable in a deterministic manner. Rather, a performance parameter of such kind will most likely end up in an interval or tolerance corridor. So rather than a performance parameter being required to have one exact value, it may be considered sufficient if that actual value is below, or above, certain threshold, or in other cases inside, or outside, a certain interval.

In order to fulfil product specifications, originating e.g. from customer and/or certification requirements, a significant effort goes into ensuring that performance parameters are met.

Technical systems, in particular technical systems with at least two energy conversion devices, can still be improved, in particular with regard to an efficient and economic production, while ensuring the fulfilment of performance parameters, such as energy conversion device and/or technical system related parameters.

It is therefore desirable to address at least one of the above drawbacks.

### BRIEF SUMMARY

In accordance with a first aspect of the present disclosure, a method for producing a technical system comprising at least two energy conversion devices is proposed, the method comprising:
- defining a threshold value for a performance parameter,
- defining a plurality of pairs of energy conversion devices from an available set of energy conversion devices;
- generating a combined performance parameter for each pair of the plurality of pairs of energy conversion devices;
- determining a difference between the combined performance parameter and the threshold value for each pair of the plurality of pairs of energy conversion devices; and
- determining a selected pair by selecting the pair of energy conversion devices having the smallest difference to the threshold value.

The present disclosure includes the finding, that certain requirements are relevant on a higher, e.g. technical system level, and thus may be fulfilled by a plurality of energy conversion devices in conjunction, rather than by each energy conversion device individually on an energy conversion device level. The at least two energy conversion devices are pairable. The at least two energy conversion devices may be of substantially identical type, such that the energy conversion devices only differ, if at all, in details, such as the mounting side, that are negligible for determining the performance parameter. Hence, it may be feasible to consider a performance parameter on a level higher than the energy conversion device itself, for example on a technical system level or energy conversion device pair level, in the form of the combined performance parameter. By doing so, one is able to match at least two energy conversion devices, that in conjunction fulfill a needed requirement, i. e. which together have a combined performance parameter meeting a desired threshold value. In other words, one energy conversion device of an energy conversion device pair can compensate another, paired energy conversion device with respect to the performance parameter.

The available set of energy conversion devices may be a plurality of already produced energy conversion devices in stock, that are available for shipping and/or the assembly at a technical system. 'Defining a plurality of pairs of energy conversion devices' in particular does not imply any physical modification, or mounting of said energy conversion devices, but rather theoretically assigning pairs of all possible combinations of available energy conversion devices, in order to calculate their combined performance parameters and assess their performance as a pair. By generating the combined performance parameter for each of the assigned pairs, an optimized matching can be achieved with the respect to the (combined) performance parameter. In addition to ensuring that the performance parameter is fulfilled by a specified pair of energy conversion devices, it can also be ensured that e. g. energy conversion device pairs do not unnecessarily 'overachieve', but that the pair is chosen that is closest to the threshold value, i. e. having a combined performance parameter with the smallest difference to the threshold value. By the proposed method, it is thus possible to match energy conversion devices to combine energy conversion device sets with less variance with respect to the combined performance parameter, i. e. less and/or weaker outliers in either direction,

Further developments of the disclosure can be found in the dependent claims and show particularly advantageous possibilities to realize above-described concept in light of the object of the disclosure and regarding further advantages.

The threshold value may delimit a fulfilment range of the performance parameter, and the selected pair may be further required to have a combined performance parameter within the fulfilment range. In such a development of the disclosure, the threshold defines an upper or lower boundary of a fulfilment range. In particular, the threshold defines a one-sided interval. The fulfilment range e g. may range from 0 to the threshold value, or, alternatively, from the threshold value to infinity. The fulfilment range can be described as the range of values of the performance parameter (or combined performance parameters), in which the energy conversion device (or energy conversion device pair, respectively) fulfils the requirements of the performance parameter.

The threshold value may be a static threshold value. Such static threshold value may be based on historic data, or estimation, or simulation, or modelling, or legal requirements, or customer requirements. Such static threshold may also be particularly useful in cases where a statistical basis does not (yet) exist, for example if a number of previous energy conversion devices of one energy conversion device type, or in a production sequence, is smaller than a minimum value (e.g. 50).

In other developments, the threshold value may be a dynamic threshold value, based on the average value of the performance parameter for a number of previous energy conversion devices of one energy conversion device type, or in a production sequence. Alternatively, the dynamic threshold value may be the average value of combined performance parameters of a number of, e. g. 20 or 50 or 100, previously selected pairs. A dynamic threshold value may particularly advantageous if a number of previous energy conversion devices in a production sequence is equal to or greater than a minimum value (e.g. 50).

By using a dynamic threshold, the threshold value can be adapted to current developments of the design and/or production. For example, if, e.g. due to an improved manufacturing process, an improvement of the performance parameter is achieved, and consequently, the mean value for that performance parameter for plurality of energy conversion devices improves, this improvement can be reflected in the pairing process by adjusting the threshold value accordingly. Using the combined performance parameter of selected pairs as a basis for calculation of the dynamic threshold, the pairing method can adapt to the improved combined performance parameters achieved through previously selected pairs (matched energy conversion device sets).

In a further development, the method may further comprise removing the selected pair from the available set of energy conversion devices, and/or adding a new pair of energy conversion devices to the available set of energy conversion devices. In other words, newly produced energy conversion devices may be added to the available set of energy conversion devices, for them to be considered in the pairing method. Likewise, energy conversion devices of a selected pair of energy conversion devices, that has been shipped and which energy conversion devices are thus not in the available set of energy conversion devices anymore, may be removed.

In a further development, the method may further comprise shipping the selected pair of energy conversion devices. Such shipping may include the packaging and/or transport to an assembly site.

In a further development, the method may further comprise attaching the selected pair of energy conversion devices to a technical system, in particular to a vehicle. The vehicle may be an aircraft or a ship. The attaching may comprise, among other things, establishing a mechanical and/or electrical and/or hydraulic and/or signal-wise connection to the technical system.

The selected pair may be further required to have a difference equal to or smaller than 20 % of the threshold value. Any other value for the difference may be possible, such as 50%, 40%, 30%, 25%, 15%, 10%, 5 %. Such requirement ensures that certain minimum standard / requirement fulfilment is maintained, independent of the absolute values of the performance parameter of the available energy conversion devices. In other words, an energy conversion device pair may not be selected, even if its combined performance parameter has the smallest difference to the threshold value, when its absolute value remains below a minimum standard.

Each pair may comprise a left energy conversion device and a right energy conversion device. The available set of energy conversion devices may comprise a subset for available left energy conversion devices and a subset for available right energy conversion devices. It may be advantageous or even necessary to distinguish such subset, in particular if characteristics related to the assembly position of the energy conversion devices in the technical system, such as orientation of mounting brackets, orientation of rotation or the like parameters are to be considered when selecting a pair of energy conversion devices.

The performance parameter may be one of: a specific fuel consumption parameter, a weight parameter, a turbine gas temperature parameter. Such performance parameters may be suitable for a compensation on pair and/or technical system level, as described above. In other words, an energy conversion device with a better performance parameter may be used to compensate an energy conversion device with a lower performance parameter. In total, the selected pair and/or the technical system may then the fulfil the requirement described by the performance parameter. The specific fuel consumption parameter generally describes how much fuel an engine burns each hour, in particular under specified conditions, and may have the unit [Kilogram/Hour]. The specific fuel consumption parameter may be a thrust specific fuel consumption parameter, having the unit [Kilogram/(Hour x Newton)]. Other definitions of specific fuel consumption parameters known in the art may be used. Definitions of specific fuel consumption parameters are known in the art, e.g. available under https://www.grc.nasa.gov/www/k-12/airplane/sfc.html.

The technical system may be an aircraft or a ship, or any other technical system with a plurality of at least two energy conversion devices for propulsion. The method may be computer-implemented.

In a second aspect of the disclosure, an apparatus is proposed, the apparatus comprising at least one processor, at least one memory comprising computer readable instructions; the at least one processor being configured to read the computer readable instructions to cause performance of the method according to the first aspect of the disclosure.

In a third aspect of the disclosure, a computer program is proposed that, when read by a computer, causes performance of the method according to the first aspect of the disclosure.

In a fourth aspect of the disclosure, a non-transitory computer readable storage medium is proposed, comprising computer readable instructions that, when read by a computer, cause performance of the method according to the first aspect of the disclosure.

In a fifth aspect of the disclosure, an energy conversion device set is proposed, comprising a selected pair of energy conversion devices, selected according to the method of the first aspect of the disclosure. The energy conversion device set may be the selected pair of energy conversion devices. The energy conversion device set may be an engine set, comprising at least two engines.

In a sixth aspect of the disclosure, a technical system is proposed, in particular aircraft or ship, produced by a method according to the first aspect of the disclosure, and/or comprising at an energy conversion device set according to the second aspect of the disclosure.

The skilled person will appreciate that except where mutually exclusive, a feature described in relation to any one of the above aspects may be applied mutatis mutandis to any other aspect. Furthermore, except where mutually exclusive, any feature described herein may be applied to any aspect and/or combined with any other feature described herein.

### BRIEF DESCRIPTION

These and other aspects of the disclosure will be apparent from and elucidated with reference to the embodiments described hereinafter. The embodiments of the disclosure are described in the following on the basis of the drawings. The latter is not necessarily intended to represent the embodiments to scale. Drawings are, where useful for explanation, shown in schematized and/or slightly distorted form. With regard to additions to the teachings immediately recognizable from the drawings, reference is made to the relevant state-of-the-art. It should be borne in mind that numerous modifications and changes can be made to the form and detail of an embodiment without deviating from the general idea of the disclosure. The features of the disclosure in the description, in the drawings and in the claims may be essential for a further development of the disclosure either individually or in any combination.

In addition, all combinations of at least two of the features disclosed in the description, drawings and/or claims fall within the scope of the disclosure. The general idea of the disclosure is not limited to the exact form or detail of the preferred embodiment shown and described below, or to an object which would be limited in comparison to the object claimed in the claims. For specified design ranges, values within the specified limits are also disclosed as limit values and thus arbitrarily applicable and claimable.

Further advantages, features and details of the disclosure result from the following description of the preferred embodiments as well as from the drawings, which show in:
- Fig. 1: a schematic illustration of a technical system according to the concept of the disclosure, comprising a selected pair of energy conversion devices.
- Fig. 2: a schematic illustration of an apparatus according to the concept of the disclosure;
- Fig. 3: a first embodiment of a method according to the concept of the disclosure in a schematic step sequence;
- Fig. 4: a graph illustrating a distribution of performance parameter values for an available set of energy conversion devices.

### DETAILED DESCRIPTION

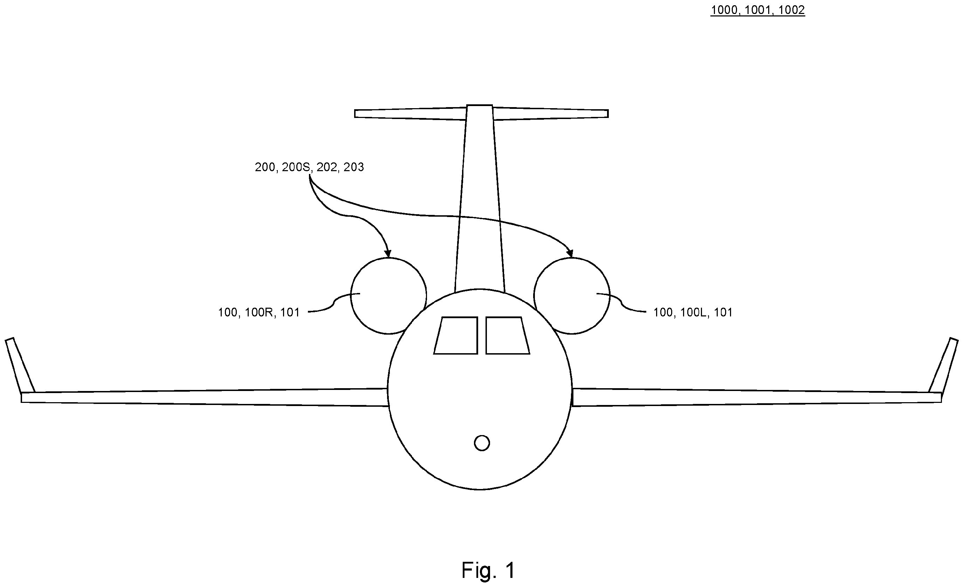

Fig. 1 illustrates a schematic of a technical system 1000, here a vehicle 1001 in the form of an aircraft 1002, comprising an energy conversion device set 202 with a selected pair 200S of energy conversion devices 100, selected by a method according to the concept of the disclosure. In the present embodiment, the energy conversion devices 100 are engines 101, namely gas turbine engines, and accordingly the energy conversion device set 202 is an engine set 203. That is, the selected pair 200S is a pair 200 that has been selected from an available set K of energy conversion devices 100, according to the criteria described above. The energy conversion device set 202, and likewise the selected pair 200S, comprises one right energy conversion device 100R and one left energy conversion device 100L, which may differ from each other e. g. with respect to the position of mounting brackets.

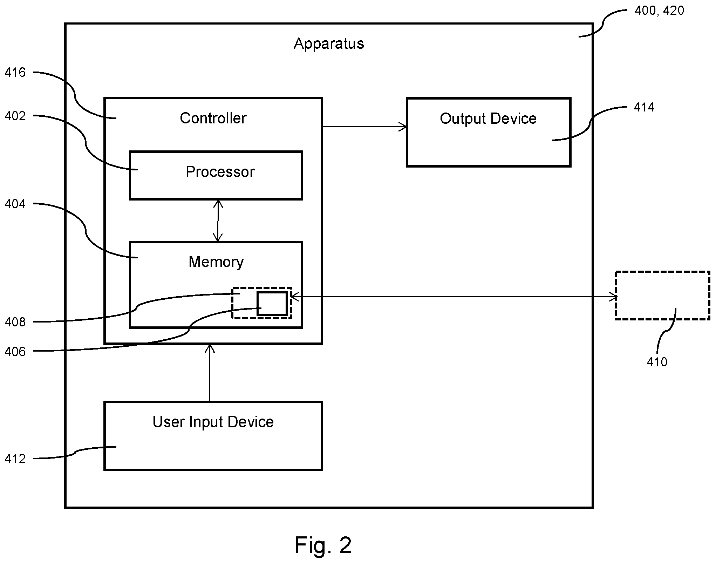

Fig. 2 illustrates a schematic diagram of an apparatus 400 according to various examples. The apparatus 400 may include, as it is the case here, a control circuitry 416, a user input device 412, and an output device 414. In some examples, the apparatus 400 may be a module. As used herein, the wording 'module' refers to a device or apparatus where one or more features are included at a later time and, possibly, by another manufacturer or by an end user. For example, where the apparatus 400 is a module, the apparatus 400 may only include the control circuitry 416, and the remaining features may be added by another manufacturer, or by an end user. In some examples, the apparatus 400 may be, or may be part of, a personal computer.

The control circuitry 416, the user input device, and the output device 414 may be coupled to one another via a wireless link and may consequently comprise transceiver circuitry and one or more antennas. Additionally or alternatively, the control circuitry 416, the user input device and the output device may be coupled to one another via a wired link and may consequently comprise interface circuitry (such as a Universal Serial Bus (USB) socket). It should be appreciated that the control circuitry 416, the user input device 412, and the output device 414 may be coupled to one another via any combination of wired and wireless links.

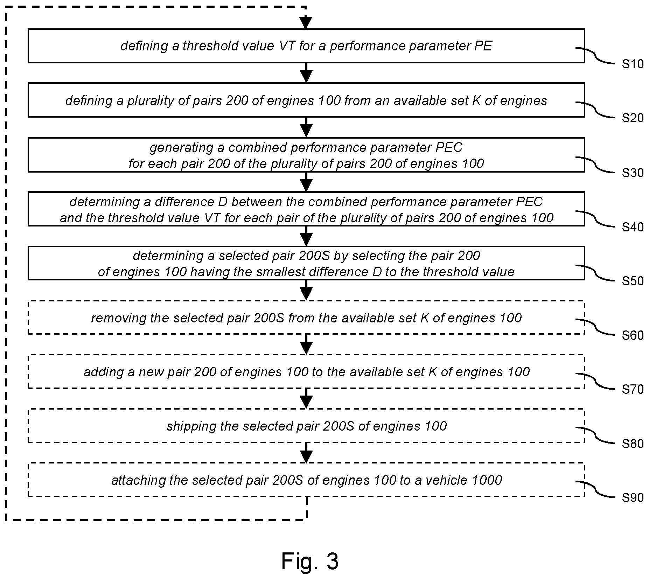

The control circuitry 416 may comprise any suitable circuitry to cause performance of the methods described herein and as illustrated in Fig. 3. The control circuitry 416 may comprise: a processor; and/or at least one application specific integrated circuit (ASIC); and/or at least one field programmable gate array (FPGA); and/or single or multi-processor architectures; and/or sequential/parallel architectures; and/or at least one programmable logic controllers (PLCs); and/or at least one microprocessor; and/or at least one microcontroller; and/or a central processing unit (CPU); and/or a graphics processing unit (GPU), to perform the methods.

In various examples, the control circuitry 416 may comprise at least one processor 402 and at least one memory 404. The memory 404 stores a computer program 408 comprising computer readable instructions 406 that, when read by the processor 402, causes performance of the methods described herein, and as illustrated in Fig. 3. The computer program 408 may be software or firmware, or may be a combination of software and firmware.

The processor 402 may include at least one microprocessor and may comprise a single core processor, may comprise multiple processor cores (such as a dual core processor or a quad core processor), or may comprise a plurality of processors (at least one of which may comprise multiple processor cores).

The memory 404 may be any suitable non-transitory computer readable storage medium 410, data storage device or devices, and may comprise a hard disk and/or solid state memory (such as flash memory). The memory 404 may be permanent non-removable memory, or may be removable memory (such as a universal serial bus (USB) flash drive or a secure digital card). The memory 404 may include: local memory employed during actual execution of the computer program 408; bulk storage; and cache memories which provide temporary storage of at least some computer readable or computer usable program code to reduce the number of times code may be retrieved from bulk storage during execution of the code.

The computer program 408 may be stored on a non-transitory computer readable storage medium 410. The computer program may be transferred from the non-transitory computer readable storage medium 410 to the memory 404. The non-transitory computer readable storage medium may be, for example, a USB flash drive, a secure digital (SD) card, an optical disc (such as a compact disc (CD), a digital versatile disc (DVD) or a Blu-ray disc). In some examples, the computer program 408 may be transferred to the memory 404 via a wireless signal or via a wired signal.

Input/output devices may be coupled to the system either directly or through intervening input/output controllers. Various communication adaptors may also be coupled to the controller to enable the apparatus 400 to become coupled to other apparatus or remote printers or storage devices through intervening private or public networks. Non-limiting examples include modems and network adaptors of such communication adaptors.

The user input device 412 may comprise any suitable device for enabling an operator to at least partially control the apparatus 400. For example, the user input device 412 may comprise one or more of a keyboard, a keypad, a touchpad, a touchscreen display, and a computer mouse. The control circuitry 416 is configured to receive signals from the user input device 412.

The output device 414 may be any suitable device for conveying information to a user. For example, the output device 414 may be a display (such as a liquid crystal display, or a light emitting diode display, or an active matrix organic light emitting diode display, or a thin film transistor display, or a cathode ray tube display), and/or a loudspeaker, and/or a printer (such as an inkjet printer or a laser printer). The control circuitry 416 is arranged to provide a signal to the output device 414 to cause the output device 414 to convey information to the user.

It should be appreciated that the method illustrated in Fig. 3 may be performed 'offline' on data which has been measured and recorded previously. Alternatively it may be performed in `real-time', that is, substantially at the same time that the data is measured.

Fig. 3 illustrates a flow diagram of a method according to various examples. At block S10, the method includes defining a threshold value VT for a performance parameter PE. The performance parameter PE defines a basic requirement to be fulfilled by each energy conversion device 100, wherein the threshold value VT defines a, in particular measurable, level of fulfilment of the performance parameter PE. The threshold value VT can be a static threshold value VTS. A static threshold value VTS, which is a constant numeral value, may be advantageous in cases where a number and are of previously produced energy conversion devices 100 in a production sequence and/or in an available set K is smaller than a specified value, e.g. 50 or 80. In other embodiments, the threshold value VT may be a dynamic threshold value VTD. The dynamic threshold value VTD is a variable numeral value, for example a mean value or average value of the performance parameter PE of a certain number NR of previous energy conversion devices 100 in a production sequence SP, and/or an average value of the performance parameter PE of energy conversion devices 100 in the available set K. In other embodiments, the dynamic threshold value VTD may be an average value of combined performance parameters of selected pairs 200S, previously selected by the method according to the first aspect of the disclosure. The dynamic threshold value VTD may be a rolling average of the performance parameter PE or combined performance parameter PEC.

At block S20, the method includes defining a plurality of pairs 200 of energy conversion devices 100 from an available set K of energy conversion devices 100. Defining the plurality of pairs 200 thus may not imply an actual physical pairing or assembling of energy conversion devices, but rather a theoretical matching or assigning of the energy conversion devices 100 to each other, in particular for comparing a combined performance parameter of each pair.

At block S30, the method includes generating a combined performance parameter PEC for each pair 200 of the plurality of pairs 200 of energy conversion devices 100. Generating the combined performance parameter PEC includes the calculation of a combined, i.e. common, performance parameter PEC out of two input performance parameters PE of the two energy conversion devices 100 of the pair 200. This calculation may be, or include, the calculation of the average value of the two input performance parameters PE.

At block S40, the method includes determining a difference D between the combined performance parameter PEC and the threshold value VT for each pair of the plurality of pairs 200 of energy conversion devices 100. In other words, in this block S40 the deviation of the performance parameter PEC from the threshold value VT is determined.

At block S50, the method includes determining a selected pair 200S by selecting the pair 200 of energy conversion devices 100 having the smallest difference D to the threshold value. This means, that of all values for the difference D, calculated for each pair 200, the smallest value is selected, and its corresponding pair 200 (i.e. pair 200 having the smallest difference D) will be determined as the selected pair 200S.

Optional embodiments of the method may include at block S60 removing the selected pair 200S from the available set K of energy conversion devices 100. As the available set K of energy conversion devices 100 constitutes the model of an actual stock of energy conversion devices 100 available to a production and/or assembly and/or shipping process, it is sensible to remove any selected pair 200S from said model available set K, since the selected pair 200S (i.e. its corresponding energy conversion device set 202) will not be available anymore after shipping and/or assembly.

Optional embodiments of the method may include at block S70 adding a new pair 200 of energy conversion devices 100 to the available set K of energy conversion devices 100. When newly produced energy conversion devices 100 are available (i.e. are added to the stock of available energy conversion devices 100), the available set K is updated accordingly.

The method may include at block S80 the shipping of the selected pair 200S of energy conversion devices 100. The selected pair 200S, which at that point may only be a theoretical matching of two individual energy conversion devices 100 by means of their characteristic performance parameters PE, may at this point become an actual energy conversion device set 202, which may then be assigned or assembled to one actual technical system 1000, and/or shipped to a customer. The shipping may include packaging of the energy conversion devices 100.

The method may include at block S90 attaching the selected pair 200S of energy conversion devices 100, i.e. the energy conversion device set 202 comprising the selected pair 200S of energy conversion devices 100, to a technical system 1000. In particular, the technical system 1000 may be an aircraft 1002 or a ship 1004. In other words, at least two energy conversion devices 100 of the selected pair 200S are mounted to the technical system 1000. The selected pair 200S, and the energy conversion device set limited to respectively, may comprise a left energy conversion device 100L, and a right energy conversion device 100R.

In the scope of the disclosed method, also other criteria for distinguishing the available set K are possible when assigning pairs to each other, such as: left vs right; upper vs. lower; main vs. auxiliary. Such distinguishing criteria have in common, that the available set K is divided into two subsets, and the matching, performed in block S20, takes into account an energy conversion device 100 from each subset when generating a pair 200.

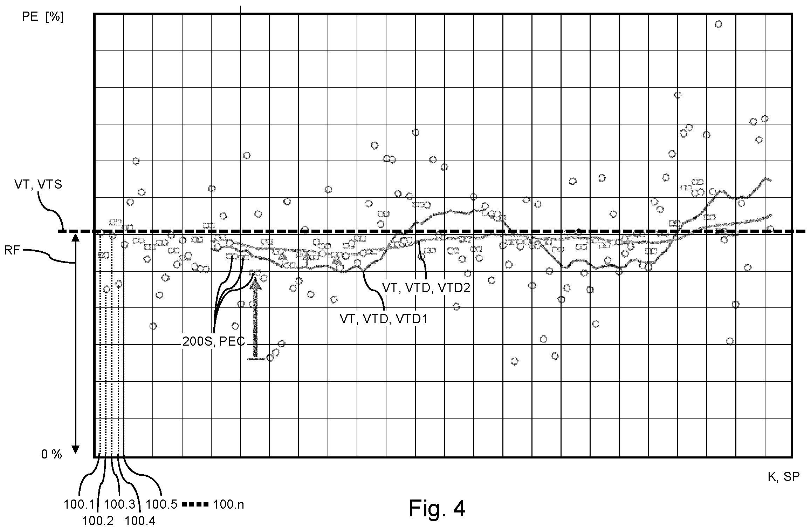

To elucidate the pairing method, a graph illustrating a plurality of performance parameters PE for an available set K of energy conversion devices 100 of a production sequence SP is shown in Fig. 4. On the x-axis, individual energy conversion devices 100 of the available set K are listed. On the y-axis, the performance parameter PE, here in the form of a specific fuel consumption parameter PSF, is specified in a normalized manner (unit: %). A performance parameter PE is illustrated by a circled dot for each individual energy conversion device 100, e.g. a first energy conversion device 100.1, second energy conversion device 100.2, up to an nth energy conversion device 100.n.

Selected pairs 200S, which are selected by the proposed method, are each indicated by an icon comprised of two adjacent box-shaped icons. Selected pairs 200S are arranged along the x-axis, according to the chronological order of their selection. In Fig. 4, of all selected pairs 200S shown, three selected pairs 200S are exemplarily indicated with a reference sign.

As a first example, a threshold value VT in the form of a static threshold value VTS is indicated by the dashed horizontal line. As the specific fuel consumption parameter PSF is required to not exceed certain threshold value VT, the threshold value VT shown here defines an upper boundary of a fulfilment range RF.

As a second example, a threshold value VT in the form of a dynamic threshold value VTD, namely a first dynamic threshold value VTD1, shown. In contrast to the static threshold value VTS, the dynamic threshold value VTD is not a constant value, but a variable, which is continuously updated as the available set K of energy conversion devices 100 changes. In the case of the second example, the first dynamic threshold value VTD1 is calculated as a rolling average of the performance parameters PE of the previous number, e.g. 50, of energy conversion devices 100 in a production sequence SP.

As a third example, another threshold value VT in the form of a second dynamic threshold value VTD2 is shown. In contrast to the first dynamic threshold value VTD1, the second dynamic threshold value VTD2 is calculated based as a rolling average of the combined performance parameters PEC of the selected pairs 200S, that were determined with the method according to the first aspect of the disclosure.

When comparing the first dynamic threshold value VTD1 and the second dynamic threshold value VTD2, it becomes apparent that the proposed pairing method has a smoothing effect on the distribution of combined performance parameters PEC of the selected pairs 200. While the graph of the first dynamic threshold value VTD1 corresponds to a rolling average of combined performance parameters PEC of energy conversion device sets paired merely according to their order in the production sequence SP, the second dynamic threshold value VTD2 corresponds to the rolling average of combined performance parameters PEC of energy conversion device sets paired according to the proposed method, aiming to optimize the combined performance parameter under consideration of the available set K of energy conversion devices 100. As a consequence, the distribution of second dynamic threshold value VTD2 is less volatile, with values in a smaller corridor around a desired value.

### List of reference signs (part of the description)

- 100: energy conversion device
- 100L: left energy conversion device
- 100R: right energy conversion device
- 101: engine set
- 200: pair of energy conversion devices
- 200S: selected pair of energy conversion devices
- 202: energy conversion device set
- 203: engine set
- 400: apparatus
- 402: processor
- 404: memory
- 406: computer readable instructions
- 408: computer program
- 410: non-transitory computer readable storage medium
- 412: user input device
- 414: output device
- 420: computer
- 1000: technical system
- 1001: vehicle
- 1002: aircraft
- 1004: ship

- D: difference between the combined performance parameter and the threshold value
- K: available set of energy conversion devices
- NR: number of previous energy conversion devices in a production sequence
- PE: performance parameter
- PEC: combined performance parameter
- PFC: specific fuel consumption parameter
- PGT: turbine gas temperature parameter
- PW: weight parameter
- RF: fulfilment range of the performance parameter
- S10: defining a threshold value for a performance parameter
- S20: defining a plurality of pairs of energy conversion devices from an available set of energy conversion devices
- S30: generating a combined performance parameter for each pair of the plurality of pairs of energy conversion devices
- S40: determining a difference between the combined performance parameter and the threshold value for each pair of the plurality of pairs of energy conversion devices
- S50: determining a selected pair by selecting the pair of energy conversion devices having the smallest difference to the threshold value.
- S60: removing the selected pair from the available set of energy conversion devices, and/or
- S70: adding a new pair of energy conversion devices to the available set of energy conversion devices.
- S80: shipping the selected pair of energy conversion devices
- S90: attaching the selected pair of energy conversion devices to a technical system, in particular to an aircraft or a ship
- SP: production sequence
- VT: threshold value
- VTD: dynamic threshold value
- VTS: static threshold value

## Claims

1. A method for producing a technical system (1000) comprising at least two pairable energy conversion devices (100), the method comprising:
- S10: defining a threshold value (VT) for a performance parameter (PE);
- S20: defining a plurality of pairs (200) of energy conversion devices (100) from an available set (K) of energy conversion devices (100);
- S30: generating a combined performance parameter (PEC) for each pair (200) of the plurality of pairs (200) of energy conversion devices (100);
- S40: determining a difference (D) between the combined performance parameter (PEC) and the threshold value (VT) for each pair of the plurality of pairs (200) of energy conversion devices (100); and
- S50: determining a selected pair (200S) by selecting the pair (200) of energy conversion devices (100) having the smallest difference (D) to the threshold value.

2. The method of claim 1, wherein
- the threshold value (VT) delimits a fulfilment range (RF) of the performance parameter (PE), and
- the selected pair (200S) is further required to have a value of the combined performance parameter (PEC) within the fulfilment range (RF).

3. The method of claim 1 or 2, wherein
- the threshold value (VT) is a static threshold value (VTS).

4. The method of claim 1 or 2, further comprising:
- the threshold value (VT) is a dynamic threshold value (VTD), based on the average value of the performance parameter (PE) for a number (NR) of previous energy conversion devices (100) in a production sequence (SP), or based on the average value of the combined performance parameter (PEC) for a number of previous selected pairs (200S).

5. The method of one of the preceding claims, further comprising:
- S60: removing the selected pair (200S) from the available set (K) of energy conversion devices (100), and/or
- S70: adding a new pair (200) of energy conversion devices (100) to the available set (K) of energy conversion devices (100).

6. The method of one of the preceding claims, further comprising:
- S80: shipping the selected pair (200S) of energy conversion devices (100), and/or
- S90: attaching the selected pair (200S) of energy conversion devices (100) to a technical system (1000), in particular to a vehicle (1001).

7. The method of one of the preceding claims, wherein
- the selected pair (200S) is further required to have a difference (D) equal to or smaller than 20% of the threshold value (VT).

8. The method of one of the preceding claims, wherein
- the energy conversion device (100) is an engine (101), and/or
- the technical system (1000) is a vehicle (1001), in particular an aircraft (1002) or a ship (1004).

9. The method of one of the preceding claims, wherein
- the performance parameter (PE) is one of: a specific fuel consumption parameter (PFC), a weight parameter (PW), a turbine gas temperature parameter (PGT).

10. The method of one of the preceding claims, wherein
- the method is computer-implemented.

11. An apparatus (400) comprising:
at least one processor (402);
at least one memory (404) comprising computer readable instructions (406);
the at least one processor (402) being configured to read the computer readable instructions (406) to cause performance of the method of one of the preceding claims.

12. A computer program (408) that, when read by a computer, causes performance of the method as claimed in any of claims 1 to 10.

13. A non-transitory computer readable storage medium (410) comprising computer readable instructions (406) that, when read by a computer (420), cause performance of the method as claimed in any of claims 1 to 10.

14. Energy conversion device set (202), in particular engine set (203), comprising a selected pair (200S) of energy conversion devices (100), selected according to the method of one of the claims 1 to 10.

15. Technical system (1000), in particular aircraft (1002) or ship (1004), produced by a method of one of claims 1 to 10 and/or comprising an energy conversion device set (202) according to claim 14.
